# EUROPEAN PATENT APPLICATION

(11) **EP 1 026 511 A2**
(43) Date of publication of application: **09.08.2000**
(21) Application number: 00101226.9
(22) Date of filing: 24.01.2000
(51) Int. Cl.: G01R 31/316

(54) **Semiconductor device**

(30) Priority: 25.01.1999 JP 1532899
(71) Applicant: Rohm Co., Ltd., Kyoto-shi Kyoto 615-8585 (JP)
(72) Inventor: Ishikawa, Hiroyuki, Kyoto 615-8585 (JP); Horiuchi, Sachito, Kyoto 615-8585 (JP)
(74) Representative: Reinhard - Skuhra - Weise & Partner

(57) **Abstract**

To measure characteristics of output elements 4-6 of a semiconductor device 1, the device is provided with a measurement terminal P10 for measuring the voltage (electric potential) at the terminals of the output elements 4-6 connected to a control circuit 3 of the device, in addition to the terminals for the output elements 4-6. Each of the output elements is connected with the measurement terminal P10 via an switching element SW1-SW4 which is selectively turned ON/OFF to read the voltage at the terminal selected by measurement data fed to the decoder.

By the use of the single measurement terminal P10, the invention permits accurate measurements of characteristics of the output elements irrespective of the contact and ohmic wiring resistances involved in the measurements, without any further terminals for the measurements.

## Description

### FIELD OF THE INVENTION

The present invention relates to a semiconductor device having a structure that allows easy measurements of characteristics of output elements connected to semiconductor circuits in the device.

### BACKGROUND OF THE INVENTION

In dealing with semiconductor devices such as ICs and LSIs, it is necessary to know precise characteristics of the output elements in the device in order to obtain good matching between the elements and external circuits to be connected therewith. However, it is difficult to obtain accurate characteristics of these output elements on account of errors caused by contact resistances for example created between the lead terminals of the semiconductor device and the lead wires of sockets of a measuring apparatus, and ohmic wiring resistances in the measuring apparatus. In particular, such measurement is difficult especially when such contact and wiring resistances significantly affect the measurement, which is the case. For MOS transistors and junction type transistors having a low ON-resistance (e.g., a few ohms) (which is the resistance while the transistor is turned on), and large current regulators (designed for example for 100 mA and up).

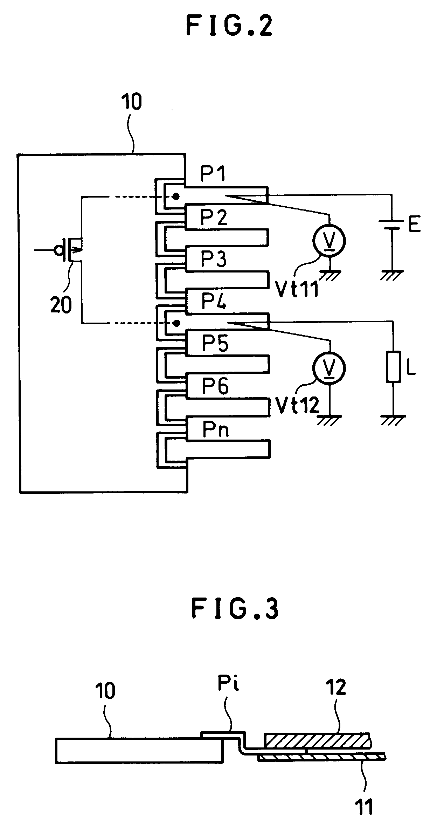

To see this, a brief description of convention characteristics measurements of output elements of a semiconductor device will be given below with reference to Figs. 2 through 5.

Fig. 2 shows a typical semiconductor device 10 having a MOS transistor connected between lead terminals P1 and P4 of the semiconductor device. The lead terminals P1 and P4 are connected with a battery E and a load L, respectively for the purpose of measuring the characteristics of the MOS transistor 20. The lead terminals P1 and P4 are also connected with DC voltmeters Vt11 and Vt12, respectively, for measuring the voltages (electric potentials) at the respective lead terminals.

In this approach, errors caused by the wiring resistances in the measuring apparatus can be eliminated, since the measurement is performed using a voltage sense line for the measurement which is separated from a current source line, so that the true voltages of the lead terminals P1 and P4 can be measured.

However, contact resistances still exist between the lead terminals P1 and P4 and the socket leads of the measuring apparatus, which contributes to errors in the measurement.

Referring to Fig. 3, there is shown another conventional arrangement of terminals for the measurement, in which each of the lead terminals, Pi, of a semiconductor 10 is provided on one side thereof with a stiffening plate 12. A socket lead 11 is connected to the opposite side of the lead terminal Pi. This arrangement may reduce contact resistance between the socket lead 11 and the lead terminal Pi by pressing the lead terminal Pi against the stiffening plate 12 so as to increase contact area between the socket lead 11 and the lead terminal Pi during the characteristics measurement.

However, in the arrangement shown in Fig. 3, the socket lead 11 tends to accumulate nonconductive materials such as oxides on the contact area as it is used for such measurements many times. Consequently, then, contact resistance between the socket lead 11 and the lead terminal Pi cannot be reduced even if a larger pressure is applied on the lead terminal Pi.

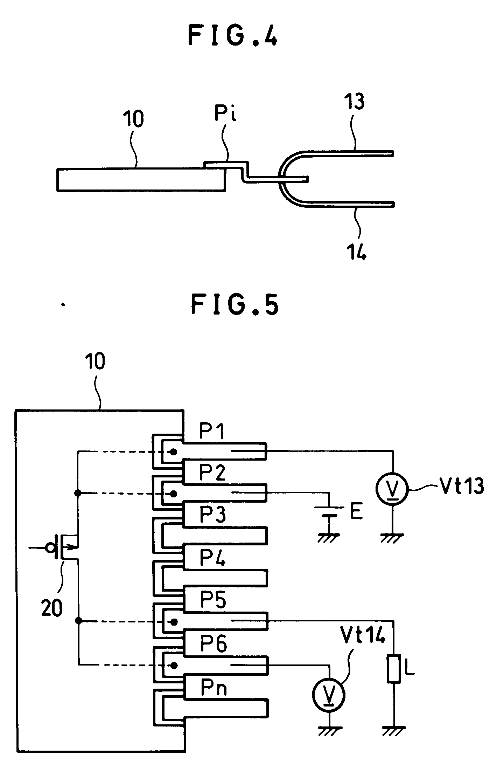

In an arrangement shown in Fig. 5, two socket leads are provided to sandwich the lead terminal Pi, with one lead 13 supplying a source current and another lead 14 sensing the voltage at the terminal. By strongly pinching the lead terminal Pi of the semiconductor 10 with the voltage sensing lead 14 and current supplying lead 13, the contact resistance between the socket lead 13 and the lead terminal Pi can be reduced.

Although this arrangement can reduce contact resistance between the lead terminal Pi and the socket lead 13 considerably, manufacture of sockets themselves is difficult when the pitch of the lead terminals Pi is increased, since this arrangement shown in Fig. 4 requires two leads for each lead terminal Pi.

A further prior art arrangement shown in Fig. 5 is intended to facilitate characteristics measurements of output elements of a semiconductor device 10 by altering positions of lead terminals of a semiconductor device itself. As seen in the figure, in order to measure characteristics of an output element, MOS transistor 20 for example, connected between lead terminals P2 and P5, has its input and output ends connected to dedicated sense lead terminals P1 and P6, respectively. The lead terminals P1, P2, P5 and P6 are connected with a DC voltmeter Vt13, a battery E, a load L, and a DC voltmeter Vt14, respectively.

In this example, the internal resistances of the voltmeter Vt13 and Vt14 are far greater than the contact and wiring resistances, so that the voltage readings of the voltmeters Vt13 and Vt14 are little affected by the contact and ohmic wiring resistances involved and hence indicate substantially true voltages at the two terminals of the MOS transistor 20, thereby enabling accurate characteristic measurements.

However, this method requires provision of sense terminals to every lead terminal of the output elements to be measured, so that the total number of terminals, and hence the dimensions, of the semiconductor device 10 must be disadvantageously increased.

Thus, any of known conventional techniques fails to eliminate errors involved in characteristics measurements of a semiconductor device due to contact and wiring resistances as mentioned above. This problem cannot be solved if additional sense terminals are provided to each of the output terminals because of an unacceptable increase in number of terminals and in overall dimension of the device.

It is therefore an object of the invention to provide a semiconductor device having only a limited number of measurement terminals for use in accurate characteristics measurements of the output terminals, without being bothered by contact and wiring resistances. A preferred semiconductor device of the invention has only one measurement terminal.

### SUMMARY OF THE INVENTION

The invention resides in a semiconductor device including:
at least one semiconductor circuit;
a multiplicity of output elements connected to said circuitry;
a measurement terminal for measuring the voltage (electric potential) at a selected end of each of said output elements; and
a multiplicity of switching elements each connected between said measuring terminal and one end of each signal output terminal, wherein
said switching elements are adapted to be selectively turned ON/OFF so as to selectively take out said voltage to said measurement terminal during a characteristics measurement of each output.

In this arrangement, because the measurement terminal is electrically separated from a circuit which supplies a current to the terminal associated with the output element under characteristics measurement, errors that would otherwise result from contact resistances between the output terminal and the socket lead and wiring resistance can be removed, thereby allowing accurate characteristics measurements for the output elements.

The semiconductor circuits preferably include a control circuit for providing the output elements with appropriate drive signals.

In addition, the control circuit preferably has input terminal for receiving serial data to operate the control circuit.

The semiconductor circuits preferably include a decoder for converting the serial data into parallel data to drive a particular output element specified by the serial data.

Upon reception of a signal indicative of a measurement of the voltage at an input/output end of the particular output element, the decoder may preferably outputs a control signal to the control circuit to drive that output element and a turn ON signal to turn on the switching element connected between the output element and the measurement terminal.

Then, the output elements may undergo normal operation when the decoder receives data for normal operations of the output elements, but when the decoder receives measurement data indicative of a characteristics measurement, the output elements may undergo an accurate characteristics measurement by connecting the output terminals to a measurement voltage source and a measurement load and connecting the measurement terminal to a voltmeter. It should be appreciated that in this arrangement only one dedicated measurement terminal is needed for such measurement, thereby increasing the total number of the lead terminals of the semiconductor device by 1.

### BRIEF DESCRIPTION OF THE DRAWINGS

Fig. 1 is a diagrammatic representation of a semiconductor device in accordance with the invention, preferable in performing a characteristics measurement of output elements of the device.
Fig. 2 shows a conventional semiconductor device under characteristics measurement.
Fig. 3 shows another conventional semiconductor device under characteristics measurement.
Fig. 4 shows a further conventional semiconductor device under characteristics measurement.
Fig. 5 shows a still further conventional semiconductor device under characteristics measurement.

### DETAILED DESCRIPTION OF THE PREFERRED EMBODIMENT

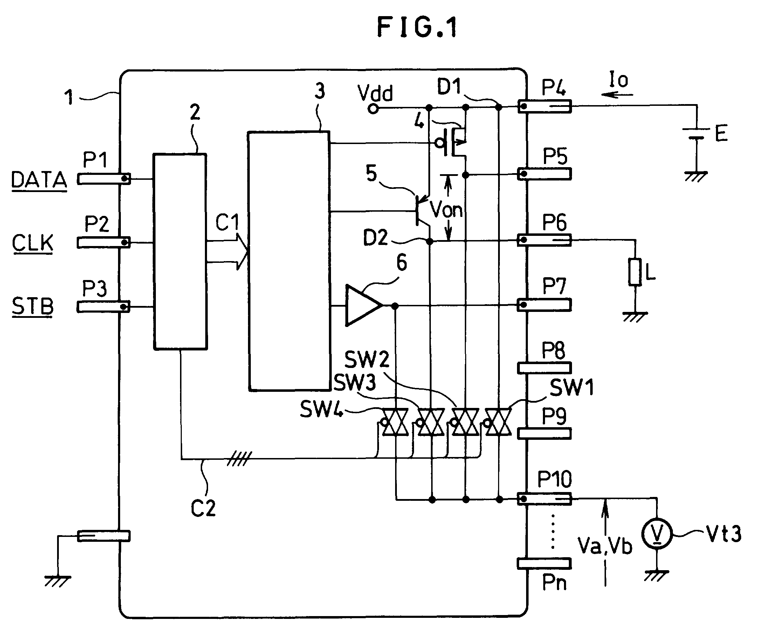

Referring now to Fig. 1, there is shown a semiconductor device 1 such as an IC and an LCI. The semiconductor device has a decoder 2, a control circuit 3, a MOS transistor 4 serving as an output element, a bipolar transistor 5, a regulator 6, a set of analog switches SW1-SW4, and a set of lead terminals P1-Pn serving as input/output terminals.

The semiconductor device 1 is supplied at the respective input terminals P1-P3 with serial input data DATA, clock signal CLK, and strobe signal STB. These signals are provided via a triplet serial input line.

The decoder 2 decodes the signals input to terminals P1-P3 via the triplet serial input line to provide control signals C1 and C2 in accordance with the decoded results. The decoder 2 has addresses for input data for characteristics measurements, so that it may decode not only normal operating signals, but also signals indicative of characteristics measurements of output elements. In the latter case, the decoder 2 outputs proper decoded signals as control signals C1 and C2 to the control circuit 3 and the switching elements, respectively.

Upon reception of the control signal C1 from the decoder 2, the control circuit 3 outputs proper drive signals to the relevant output elements such as the MOS transistor 4, bipolar transistor 5, and regulator 6. It should be understood that, during the characteristics measurement, the drive signal is supplied to one of the output elements designated by the control signal C1.

The MOS transistor 4, the bipolar transistor 5, and the regulator 6 are driven and controlled by the signals received from the control circuit 3 in response to the control signal C1. The relevant output elements are also connected to the terminals P4-P7.

Each of the analog switches SW1-SW4 is connected at one end thereof to either control voltage node Vdd (or lead terminal P4), the output terminal of the MOS transistor (or lead terminal P5), the output terminal of the bipolar transistor 5 (or lead terminal P6), or the output terminal of the regulator 6 (or lead terminal P7). The opposite ends of the switches are connected to a single common measurement terminal P10.

During the characteristics measurements of the output elements, one of the switches SW1-SW4 associated with the relevant output element is turned ON in accordance with the control signal C2 from the decoder 2.

The battery E is connected to a terminal P4 during the characteristics measurements. A DC voltmeters Vt3 and a load L are also provided for the characteristics measurement, which are connected to terminals P10 and P6, respectively.

The operation of the semiconductor device 1 during a characteristics measurement will now be described below by way of example, in particular for the bipolar transistor 5.

Input data DATA instructing characteristic measurement of the bipolar transistor 5 is input to the input terminal P1 along with clock signal CLK and strobe signal STB to the input terminals P2 and P3, respectively, via the triplet serial input line. The triplet input serial signals are decoded in the decoder 2. Upon reception of a control signal C1 from the decoder 2, the control circuit 3 supplies a drive signal to the bipolar transistor 5, which turns ON the bipolar transistor 5. Thus, a circuitry is formed to perform characteristics measurement for the bipolar transistor, in which the a DC current Io supplied by the battery E passes through the lead terminal P4, the bipolar transistor 5, the lead terminal 5, and the characteristics measurement load L.

On the other hand, the control signal C2 from the decoder 2 renders the analog switch SW1, and subsequently the switch SW3, turned ON for a predetermined period of time, in accord with the instruction for the measurement of the bipolar transistor 5. It would be apparent to those skilled in the art that the order of operating the switches is irrelevant and may be reversed.

It should be appreciated that only one terminal P10 is provided for the characteristics measurement. The voltage Va at the lead terminal P10 is measure by the DC voltmeter Vt3 while the analog switch SW1 is turned ON. Next, the analog switch SW1 is turned OFF and the analog switch SW3 is turned ON to measure the voltage Vb at the lead terminal P10 by the DC voltmeter Vt3.

In this measurement, it is true that there exist ohmic resistances in the analog switches SW1-SW4 and contact resistances associated with the sense terminal (lead terminal P10) and the socket leads. However, the resistance of the DC voltmeter Bt3 connected with the lead terminal P10 is overwhelmingly larger than the former resistances, so that the former resistances introduces no appreciable error in the characteristics measurement.

As a result, the voltage Va as measured by the DC voltmeter Vt3 can be considered as the electric potential at the node D1 in the characteristics measurement circuitry, that is, voltage Va is the voltage at the upper end of the bipolar transistor 5. The voltage Vb subsequently measured by the DC voltmeter is the voltage at the node D2 in the characteristics measurement circuitry with the analog switch SW3 turned ON, that is, the value Vb is the voltage at the lower end of the bipolar transistor 5.

Thus, in the measurement of these voltages, Va and Vb, errors that results from the contact resistances associated with the lead terminals P4 and P5 and other wiring resistances can be eliminated, thereby providing substantially true voltage Von (which will be referred to as ON-voltage) across the bipolar transistor 5 in its conductive state.

It could be understood from this example that the resistance of the bipolar transistor 5 while it is turned on (which resistance will be referred to as ON-resistance) can be obtained by measuring the DC current Io supplied from the battery E, and by calculating the ratio Von/Io.

While the present invention has been particularly shown and described with reference to a preferred embodiment for a bipolar transistor 5, it will be understood by those skilled in the art that the invention may be applied to different types of output elements. For example, similar measurements as described above can be performed using a fewer number of lead terminals.

In this manner, the invention is capable of accurately measuring a wide range of voltage (e.g. a few volts of MOS transistor and a bipolar transistor to a fairly large ON voltage of a large current regulator dealing with 100 mA, for example) as well as ON-resistances of these elements, irrespective of contact resistances between lead terminals and socket leads and ohmic wiring resistances of a measuring apparatus. By supplying measurement data, clock signals, and a strobe signal to the input end of the decoder 2 and its output to the control circuit 3 so as to drive such output element as MOS transistor 4, bipolar transistor 5, and regulator 6, and by switching one of the analog switches SW1-SW4 associated with the output element, measurements can be performed using only one extra lead terminal, thereby minimizing the total number of lead terminals of the semiconductor device 1.

In the example shown herein above, the invention has been described for a characteristics measurement of an output element which is connected at one end thereof to the voltage source E and at the other end grounded via a load using a DC voltmeter connected between said other end and the ground. It should be understood that in cases where the output element is an NMOS or an NPN transistor, the characteristics measurement can be performed equally well if one end of the output element is grounded and the other end connected to the voltage source E via a load. The ground potential may be supplied to the measurement element via a switch similar to the switch SW3. The DC voltmeter Vt3 is then connected between said other end and the voltage source E.

The switching elements may include not only analog switches as mentioned above but also other types of semiconductor elements such as PMOS transistors and PNP transistors when said one end of the output element is connected the voltage source E and said other end of the DC voltmeter Vt3 is grounded, and NMOS and NPN transistors when said other end is grounded and said one end is connected to the voltage source E.

## Claims

1. A semiconductor device including:
at least one semiconductor circuit;
a multiplicity of output elements connected to said circuit;
a measurement terminal for measuring the voltage (electric potential) at a selected end of each of said output elements; and
a multiplicity of switching elements each connected between said measuring terminal and one end of each of said output elements, wherein
said switching elements are adapted to be selectively turned ON/OFF so as to selectively take out said voltage to said measurement terminal during a characteristics measurement of each output.

2. The semiconductor device according to claim 1, wherein said measurement element is either connected to a voltage source or grounded, via the same switching element as said switching element.

3. The semiconductor device according to claim 2, further comprising a signal input terminal for driving said control circuit.

4. The semiconductor device according to claim 3, further comprising
a decoder for decoding measurement data input to said signal input terminal, supplying a control signal to said control circuit to drive one of said output elements as designated by said measurement data, and for supplying a signal to one of said switching elements connected between said measurement terminal and one end of said one output element in response to said measurement data.

5. The semiconductor device according to claim 4, wherein
said decoder supplies said control circuit with a control signal for driving a particular one of said output elements and for selectively turning ON one of said switching elements selected in response to data (measurement data) input to said signal input terminal, said measurement data instructing the measurement of voltage at the terminal of the particular output element.
